# EUROPEAN PATENT SPECIFICATION

(11) **EP 2 389 056 B1**
(45) Date of publication and mention of the grant of the patent: **21.11.2012**
(21) Application number: 11166482.7
(22) Date of filing: 18.05.2011
(51) Int. Cl.: H05K 7/20, F24F 3/147, F24F 11/00

(54) **Computer room air conditioner with pre-cooler**
Computerraum-Kühlanlage mit Vorkühlung
Climatiseur de pièce informatique avec pré-refroidisseur

(30) Priority: 21.05.2010 US 346951 P; 13.05.2011 US 106997
(43) Date of publication of application: 23.11.2011
(73) Proprietor: Liebert Corporation, Columbus, OH 43085 (US)
(72) Inventor: Madara, Steven, Dublin, OH 43017 (US); Harvey, Thomas, Columbus, OH 43235 (US)
(74) Representative: Bryn-Jacobsen, Caelia

(56) References cited:
- US-A- 5 953 926
- US-A1- 2009 210 095
- US-A1- 2010 107 658

## Description

### FIELD

The present disclosure relates to data centers and data center cooling systems, such as data center cooling systems having computer room air conditioners.

### BACKGROUND

This section provides background information related to the present disclosure which is not necessarily prior art.

A data center is a room containing a collection of electronic equipment, such as computer servers. Data centers and the equipment contained therein typically have optimal environmental operating conditions, temperature and humidity in particular. A climate control system is utilized to maintain the proper temperature and humidity in the data center.

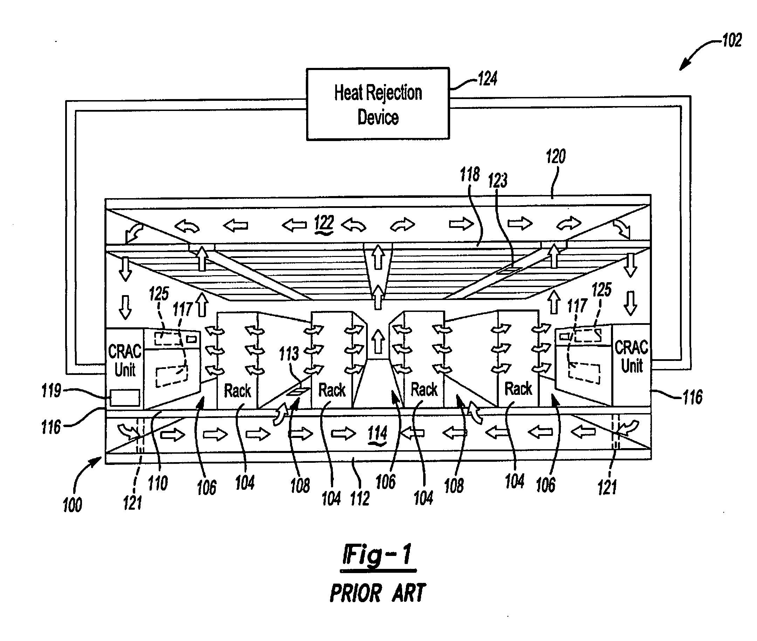

Fig. 1 shows an example of a typical data center 100 having a climate control system 102. Data center 100 illustratively utilizes the "hot" and "cold" aisle approach where equipment racks 104 are arranged to create hot aisles 106 and cold aisles 108. Data center 100 is also illustratively a raised floor data center having a raised floor 110 above a sub-floor 112, The space between raised floor 110 and sub-floor 112 provides a supply air plenum 114 for conditioned supply air (sometimes referred to as "cold" air) flowing from computer room air conditioners ("CRACs") 116 of climate control system 102 up through vents 113 (only one of which is shown in Fig. 1) in raised floor 112 into data center 100. The conditioned supply air then flows into the fronts of equipment racks 104, through the equipment (not shown) mounted in the equipment racks where it cools the equipment, and the hot air is then exhausted out through the backs of equipment racks 104.

It should be understood that data center 100 may not have a raised floor 110 nor plenum 114. In this case, the CRAC's 116 would draw in through an air inlet (not shown) heated air from the data center, cool it, and exhaust it from an air outlet 117 shown in phantom in Fig. 1 back into the data center. The CRACS 116 may, for example, be arranged in the rows of the electronic equipment, may be disposed with their cool air supply facing respective cold aisles, or be disposed along walls of the data center.

In the example data center 100 shown in Fig. 1, data center 100 has a dropped ceiling 118 where the space between dropped ceiling 118 and ceiling 120 provides a hot air plenum 122 into which the hot air exhausted from equipment racks 104 is drawn through vents 123 (only one of which is shown in Fig. 1) in ceiling 118 and through which the hot air flows back to CRACs 116.

CRACs 116 may be chilled water CRACs or direct expansion (DX) CRACs. CRACs 116 are coupled to a heat rejection device 124 that provides cooled liquid to CRACs 116. Heat rejection device 124 is a device that transfers heat from the return fluid from CRACs 116 to a cooler medium, such as outside ambient air. Heat rejection device 124 may include air or liquid cooled heat exchangers. Heat rejection device 124 may be a building chilled water system in which case chilled water is the cooled liquid provided to CRACs 116 and CRACs 116 may be chilled water air conditioning systems having chilled water valves. The chilled water valves may be on/off valves or be variable valves, such as capacity modulated valves. Heat rejection device 124 may also be a refrigeration condenser system, in which case a refrigerant is provided to CRACs 116 and CRACs 116 may be phase change refrigerant air conditioning systems having refrigerant compressors, such as a DX system. Each CRAC 116 may include a control module 125 that controls the CRAC 116.

In an aspect, CRAC 116 includes a variable capacity compressor and may for example include a variable capacity compressor for each DX cooling circuit of CRAC 116. It should be understood that CRAC 116 may, as is often the case, have multiple DX cooling circuits. In an aspect, CRAC 116 includes a capacity modulated compressor type of compressor or a 4-step semi-hermetic compressor, such as those available from Emerson Climate Technologies, Liebert Corporation or the Carlyle division of United Technologies. CRAC 116 may also include one or more air moving units 119, such as fans or blowers. The air moving units 119 may be provided in CRACs 116 or may additionally or alternatively be provided in supply air plenum 114 as shown in phantom at 121. Air moving units 119, 121 may illustratively have variable speed drives.

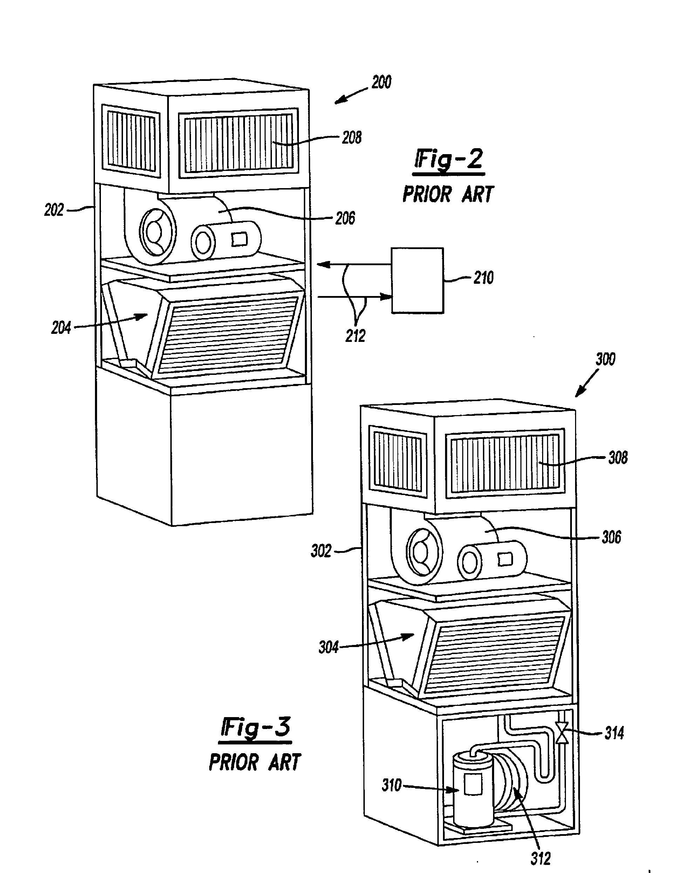

A typical CRAC 200 having a typical chilled water cooling circuit is shown in Fig. 2. CRAC 200 has a cabinet 202 in which a cooling coil 204 is disposed. Cooling coil 204 may be a V-coil. Cooling coil 204 may also be an A-coil, or a coil having an inclined slab configuration. An air moving unit 206, such as a fan or squirrel cage blower, is also disposed in cabinet 202 and situated to draw air through cooling coil 204 from an inlet (not shown) of cabinet 202, where it is cooled by cooling coil 204, and directs the cooled air out of an outlet 208, which may be a plenum. Cooling coil 204 is coupled to a source of chilled water 210, such as a water chiller, by pipes 212 so that chilled water is circulated through cooling coil 204.

A typical CRAC 300 having a typical DX cooling circuit is shown in Fig. 3. CRAC 300 has a cabinet 302 in which a cooling coil 304 is disposed. Cooling coil 304 is typically an evaporator coil, and may be a V-coil. Cooling coil 304 may also be an A-coil, or a coil having an inclined slab configuration. An air moving unit 306, such as a fan or squirrel cage blower, is also disposed in cabinet 302 and situated to draw air through cooling coil 304 from an inlet (not shown) of cabinet 302, where it is cooled by cooling coil 304, and direct the cooled air out of an outlet 308, which may be a plenum. Cooling coil 304, a compressor 310, a condenser 312 and an expansion valve 314 are coupled together in known fashion in a DX refrigeration circuit. A phase change refrigerant is circulated by compressor 310 through condenser 312, expansion valve 314, cooling coil 304 and back to compressor 304. Condenser 312 may be any of a variety of types of condensers conventionally used in cooling systems, such as an air cooled condenser, a water cooled condenser, or glycol cooled condenser. Compressor 310 may be any of a variety of types of compressors conventionally used in DX refrigeration systems, such as a scroll compressor. When cooling coil 304 is a V-coil or A-Coil, it typically has a cooling slab on each leg of the V or A, as applicable. Each cooling slab may, for example, be in a separate cooling circuit with each cooling circuit having a separate compressor. In this regard, CRAC 300 would then have multiple compressors 310. Alternatively, the fluid circuits in each slab such as where there are two slabs and two compressor circuits, can be intermingled among two compressor circuits.

Cooling coils 204, 304 are typically fin-and-tube evaporator coils and are used to both cool and dehumidify the air passing through them. Typically, CRAC's such as CRAC's 200, 300 are designed so that the sensible heat ratio ("SHR") is typically between .85 to .95.

A system known as the GLYCOOL free-cooling system is available from Liebert Corporation of Columbus, Ohio. In this system, a second cooling coil, known as a "free cooling coil," is added to a CRAC having a normal glycol system. This second coil is added in the air stream ahead of the upstream cooling coil. During colder months, the glycol solution returning from the outdoor drycooler is routed to the second cooling coil and becomes the primary source of cooling to the data center. At ambient temperatures below 1.67°C (35 deg. F (Fahrenheit)), the cooling capacity of the second cooling coil is sufficient to handle The total cooling needs of the data center and substantially reduces energy cost since the compressor of the CRAC need not be run. The second or free cooling coil does not provide 100% sensible cooling and has an airside pressure drop similar to the downstream cooling coil.

Server temperature deltas have been increasing, and in some cases have increased from the 5.5-11.1°C (10 - 20 deg. F) range to over 16.6°C (30 deg. F). A server temperature delta is the difference between the inlet and outlet (or exhaust) temperatures of the air circulated through the server to cool it. This increase in server temperature deltas has in turn increased the temperature difference across the CRACs. The temperature difference across the CRAC is the difference in temperature between the air being drawn into the cooling coil of the CRAC and the cooled air exiting the CRAC. The temperature difference across a typical chilled water CRAC and a typical DX CRAC is about 11.1°C (20 deg. F). If the temperature difference across the CRAC is less than the server temperature delta, than the air flow to the server must be increased to provide the requisite cooling for the server. This will generate excessive air flow bypass that will return to the CRAC, wasting some of the cooling. Additionally, as server loads have increased, the proportion of sensible heat load in the data center has increased compared to the latent heat load, thus increasing the sensible heat ratio (SHR) requirements.

US 2010/107658 relates to a cooling system and method for cooling devices housed in the data center. A cabinet housing a set of condenser coils is located within the data center positioned on its floor and including fans for drawing air pass the condenser coils and exiting the device angularly to the floor of the data center.

US 5953926 relates to a heating cooling system including dehumidification and energy recovery capability. This system includes two or more heat point circuits operating singularly or in concert to provide heating, singularly or in concert in reverse to provide cooling, or concurrently but oppositely to provide the dehumidification only, dehumidification concurrently with heating, or dehumidification concurrently with cooling.

The present invention is set out in the independent claim, with some optional feature set out in the claims dependent thereto.

### SUMMARY

This section provides a general summary of the disclosure, and is not a comprehensive disclosure of its full scope or all of its features.

In accordance with an aspect of the present disclosure, a computer room air conditioner ("CRAC") has a cabinet having an air inlet through which return air from an area is drawn and an air outlet through which air cooled by the CRAC is exhausted. An air moving unit is disposed in the cabinet as are a plurality of cooling coils, which are in separate cooling circuits. The cooling coils are arranged so that the air passes through the cooling coils in serial fashion, that is, first through an upstream cooling coil and then through a downstream cooling cool. If there are more than two cooling circuits, then the air passes in turn through each subsequent downstream cooling coil of each subsequent downstream cooling circuit. Each upstream cooling coil acts as a pre-cooler to the subsequent downstream cooling coil. The CRAC includes a controller that controls the cooling provided by the cooling circuits. The controller controls the cooling provided by at least the most upstream cooling circuit so that it provides only sensible cooling. That is, the cooling provided by the most upstream cooling circuit is controlled so that is it provides one hundred percent sensible cooling. In an aspect, the most upstream cooling circuit is used to provide all the cooling.

In an aspect, the most downstream cooling circuit is controlled to provide any additional sensible cooling that may be needed as well as any latent (dehumidification) that may be needed and all the cooling circuits upstream of the most downstream cooling circuit are controlled to provide only sensible cooling. In an aspect, the most downstream cooling circuit is used to provide all the cooling and is controlled to provide sensible cooling and such latent cooling that may be needed.

In an aspect, at least the most upstream cooling coil is a microchannel cooling coil and at least the most downstream cooling coil is a fin-and-tube cooling coil.

In an aspect, the cooling coils are fin-and-tube cooling coils.

In an aspect, the cooling coils are microchannel cooling coils.

In an aspect, the cooling coil of the most upstream cooling circuit is positioned at the air inlet of the CRAC. In aspect, the cooling coil of the most upstream cooling circuit is positioned at an inlet of the cooling coil of the next downstream cooling circuit.

In an aspect, the most upstream cooling circuit is a pumped refrigerant cooling circuit. In an aspect, the most upstream cooling circuit is a chilled water cooling circuit. In an aspect, the most upstream cooling circuit is a DX cooling circuit. In an aspect, the most downstream downstage cooling circuit is a DX cooling circuit. In an aspect, the most downstream cooling circuit is a chilled water cooling circuit. In an aspect, the most downstream downstage cooling circuit is a pumped refrigerant cooling circuit.

In an aspect, the downstream cooling coil is disposed in the cabinet and the upstream cooling coil is in an air inlet plenum outside the cabinet which is coupled to the air inlet of the cabinet.

In an aspect, the upstream cooling circuit cools air passing through the upstream cooling coil sufficiently so that a cooling capacity of the downstream cooling circuit is sufficient to reduce a temperature of the air passing through the downstream cooling to below a dew point of the air to provide latent cooling.

In an aspect, the upstream cooling circuit increases a temperature delta across the computer room air conditioner by at least 5.5°C (ten degrees Fahrenheit).

Further areas of applicability will become apparent from the description provided herein. The description and specific examples in this summary are intended for purposes of illustration only and are not intended to limit the scope of the present disclosure.

### DRAWINGS

The drawings described herein are for illustrative purposes only of selected embodiments and not all possible implementations, and are not intended to limit the scope of the present disclosure.

Fig. 1 is a schematic illustrating a prior art data center;

Fig. 2 is a simplified perspective view of a prior art CRAC having a chilled water cooling circuit;

Fig. 3 is a simplified perspective view of a prior art CRAC having a DX cooling circuit;

Fig. 4 is a schematic of a CRAC in accordance with an aspect of the present disclosure with an upstream cooling circuit and a downstream cooling circuit;

Fig. 5 is a simplified perspective view of a CRAC having the cooling circuits of the CRAC of Fig. 4 and

Fig. 6 is a schematic of a CRAC in accordance with an aspect of the present disclosure with two upstream cooling circuits and a downstream cooling circuit.

Corresponding reference numerals indicate corresponding parts throughout the several views of the drawings.

### DETAILED DESCRIPTION

Example embodiments will now be described more fully with reference to the accompanying drawings.

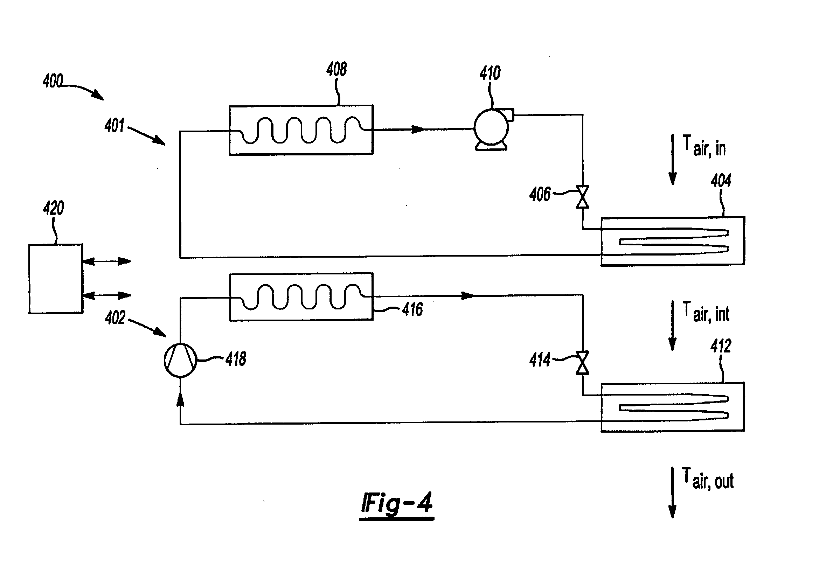

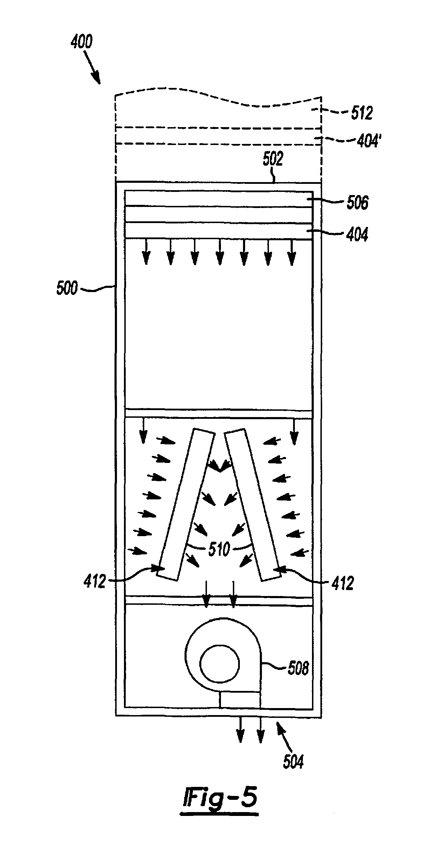

Fig. 4 is a simplified schematic of a CRAC 400 having an upstream cooling circuit 401 and a downstream cooling circuit 402 in accordance with an aspect of the present disclosure. It should be understood that cooling circuits 401, 402 are illustratively separate cooling circuits. In the embodiment of Fig. 4, upstream cooling circuit 401 is a pumped refrigerant cooling circuit and downstream cooling circuit 402 is a DX refrigeration circuit. Upstream cooling circuit 401 includes a cooling coil 404 (sometimes referred to herein as upstream cooling coil 404), flow regulator 406, condenser 408 and pump 410 arranged in a pumped refrigerant cooling circuit such as is disclosed in US 2005/120737 (U.S. Pat. Appln. Serial No. 10/904,889) owned by the owner of the present application. Downstream cooling circuit 402 includes a cooling coil 412 (sometimes referred to herein as downstream cooling coil 412), expansion valve 414, condenser 416 and compressor 418 arranged in a conventional DX refrigeration circuit. In the pumped refrigerant cooling circuit illustratively used for upstream cooling circuit 401, pump 410 circulates a phase change refrigerant throughout upstream cooling circuit 401 by pumping it so that it flows through flow regulator 406, upstream cooling coil 404 (which is illustratively an evaporator), through condenser 408 and back to pump 410. Pumping the refrigerant with pump 410 increases the pressure of the refrigerant but without appreciably increasing its enthalpy. In the DX cooling circuit illustratively used for downstream cooling circuit 402, a phase change refrigerant is circulated by the compressor 418 so that it flows from the compressor 418, through the condenser 416, expansion valve 414, downstream cooling coil 412 (which is illustratively an evaporator) and back to the compressor 418. The cooling coils 404, 412 of upstream and downstream cooling circuits 401, 402 are arranged so that air drawn in through an inlet of the CRAC flows in serial fashion through cooling coils 404, 412, that is, the air flows first through the upstream cooling coil 404 of upstream cooling circuit 401 and then through the downstream cooling coil 412 of the downstream cooling circuit 402. In this regard, upstream cooling circuit 401 is a pre-cooling circuit in that upstream cooling coil 404 cools air before the air flows through the downstream cooling coil 412 of the downstream cooling circuit 402. CRAC 400 includes an air moving unit, such as air moving unit 508 (Fig. 5) which may illustratively be a fan or blower, that pulls the air into CRAC 400, through cooling coils 404, 412, and out an air outlet of CRAC 400.

It should be understood that upstream cooling circuit 401 can be other than a pumped refrigerant cooling circuit, such as a chilled water cooling circuit or a DX refrigeration circuit. It should be understood that downstream cooling circuit 402 can be other than a DX refrigeration circuit, such as a chilled water cooling circuit or a pumped refrigerant cooling circuit.

Condenser 408 of upstream cooling circuit 401 may in particular preferably be a building chilled water heat rejection device as described above with regard to heat rejection device 124 of Fig. 1. However, it should be understood that condensers 408, 416 can be any of the heat rejection devices described above with regard to heat rejection device 124 of Fig. 1.

CRAC 400 includes a controller 420 that controls cooling circuits 401, 402. Controller 420 controls upstream cooling circuit 401 so that it provides one-hundred percent sensible cooling. It does so by controlling the temperature of the cooling fluid (such as a phase change refrigerant) flowing in upstream cooling circuit 401 so that when it passes through upstream cooling coil 404 of upstream cooling circuit 401, the temperature of the refrigerant is above the dew point of the air flowing through upstream cooling coil 404. The air flowing through upstream cooling coil 404 is typically the return air from the area being cooled by CRAC 400 that is drawn into CRAC 400 through the return air inlet of CRAC 400. In an aspect, controller 420 controls downstream cooling circuit 402 to provide any additional sensible cooling that may be needed as well as any latent cooling that may be needed. In some cases, upstream cooling circuit 401 can provide all the sensible cooling required and if no latent cooling is required, upstream cooling circuit 401 then provides all the cooling and controller 420 controls upstream and downstream cooling circuits 401, 402 so that upstream cooling circuit provides all the cooling, which is only sensible cooling. In other cases, downstream cooling circuit 402 provides additional sensible cooling and/or latent cooling, depending on whether additional sensible cooling is needed, whether latent cooling is needed, or whether both latent cooling and additional sensible cooling are needed and is controlled accordingly by controller 420. In yet other cases, such as where the total cooling load is light and latent cooling is needed, the downstream cooling circuit 402 can be used to provide all the cooling and is controlled accordingly by controller 420 which also controls upstream cooling circuit 401 so that it is not providing cooling.

In an aspect, upstream cooling coil 404 of upstream cooling circuit 401 is a microchannel cooling coil. Upstream cooling coil 404 may illustratively be a microchannel heat exchanger of the type described in US 2009/211743 (USSN 12/388,102 filed February 18, 2009) for "Laminated Manifold for Microchannel Heat Exchanger". Upstream cooling coil 404 may illustratively be a MCHX microchannel heat exchanger available from Liebert Corporation of Columbus, Ohio. While one advantage of using a microchannel cooling coil for cooling coil 404 of upstream cooling circuit 401 is that microchannel cooling coils have air side pressure drops across them that are significantly less than fin-and-tube cooling coils having comparable cooling capacity, it should be understood that cooling coil 404 can be other than a microchannel cooling coil, and may for example be a fin-and-tube cooling coil.

In an aspect, downstream cooling coil 412 of downstream cooling circuit 402 is a fin-and-tube cooling coil. It should be understood, however, that downstream cooling coil 412 can be other than a fin-and-tube cooling coil, and may for example be a microchannel cooling coil. In this case, both the upstream and downstream cooling circuits 401, 402 are operated to provide sensible cooling only.

Fig. 5 shows an illustrative embodiment of CRAC 400. CRAC 400 includes a cabinet 500 having a return air inlet 502 and an air outlet 504, such as a plenum. An air filter 506 is disposed at return air inlet 502 so that air flowing into CRAC 400 through return air inlet 502 flows through air filter 506 before flowing through the rest of CRAC 400.

In the embodiment shown in Fig. 5, downstream cooling coil 412 of downstream cooling circuit 402 is an A-coil and is disposed in cabinet 500 between return air inlet 502 and air outlet 504. Downstream cooling coil 412 thus has a cooling slab 510 on each leg of the A. An air moving unit 508, such as a fan or squirrel cage blower, is disposed in cabinet 500 between a downstream side of downstream cooling coil 412 and air outlet 504. Upstream cooling coil 404 of upstream cooling circuit 401 may illustratively be disposed in cabinet 500 at return air inlet 502, preferably after air filter 506. It should be understood that upstream cooling coil 404 could be positioned in cabinet 500 anywhere between return air inlet 502 and downstream cooling coil 412. It should be understood that upstream cooling coil 404 could be single cooling slab, or could be segmented into multiple cooling slabs, as could downstream cooling coil 412. It should also be understood that upstream cooling coil 404 could be configured as a rectangular cooling slab, as shown in Fig. 5, or could be configured as an A-coil similar to the configuration of downstream cooling coil 412. Upstream and downstream cooling coils 404, 412 could also be V-coils. Upstream cooling coil 404 may illustratively be configured so that when it is positioned in cabinet 500, it has a sealing configuration so that air flowing from air inlet 502 to downstream cooling coil 412 of downstream cooling circuit 402 must flow through upstream cooling coil 404. In the embodiment shown in Fig. 5, air moving unit 508 is utilized to draw air through both upstream cooling coil 404 of upstream cooling circuit 401 and downstream cooling coil 412 of downstream cooling circuit 402.

It should be understood that upstream cooling coil could be disposed inside an air inlet plenum 512 outside of cabinet 500 that is coupled to return air inlet 502 of cabinet 500, as shown in phantom in Fig. 5 with the upstream cooling coil designated by reference number 404'. This configuration may illustratively be utilized when adding upstream cooling circuit 401 to a CRAC, such as retrofitting a CRAC to add upstream cooling circuit 401.

By providing upstream cooling circuit 401 with cooling coil 404 that pre-cools the air before it flows into cooling coil 412 of downstream cooling circuit 402, the maximum temperature delta of CRAC 400 can be increased thus increasing the cooling capacity of CRAC 400. For example, a typical CRAC having a DX refrigeration circuit may have a maximum temperature delta of 11.1°C (about 20 deg. F). Upstream cooling circuit 401 with cooling coil 404 may illustratively be configured to add an additional 5.5°C (ten deg. F) of temperature delta across the CRAC, increasing the maximum temperature delta across the CRAC to about 16.6°C (thirty deg. F).

Upstream cooling circuit 401 may be a retrofit kit for existing CRACs, or may be installed during the manufacture of the CRAC. In this regard, by adding upstream cooling circuit 401 to a CRAC that otherwise is unable to provide latent cooling to dehumidify the air, the cooling circuit of the CRAC, which will then be a downstream cooling circuit, may then be able to provide latent cooling. For example, the temperature of the air entering a CRAC may be sufficiently high that the cooling circuit of the CRAC is not able to provide sufficient cooling to reduce the temperature of the air as it passes through the cooling cool of this cooling circuit to below the dew point, and thus CRAC is not able to provide latent cooling. By adding upstream cooling circuit 401, the air is pre-cooled before it reaches the cooling coil of the cooling circuit of the CRAC, which is now a downstream cooling circuit. Since the temperature of the air entering the cooling coil of the downstream cooling circuit has been lowered, the downstream cooling circuit then has sufficient cooling capacity to reduce the temperature of the air passing through its cooling coil to below a dewpoint of the air and can thus provide latent cooling. In this regard, upstream cooling circuit 401 cools the air passing through upstream cooling coil 404 sufficiently so that a cooling capacity of downstream cooling circuit 402 is sufficient to reduce a temperature of the air passing through downstream cooling coil 408 to below a dew point of the air to provide latent cooling.

In a an aspect, a CRAC with both upstream cooling circuit 401 and downstream cooling circuit 402 can be optimally controlled by controller 420 to use the most efficient of the upstream cooling circuit 401 and downstream cooling circuit 402 based on heat load and environmental conditions.

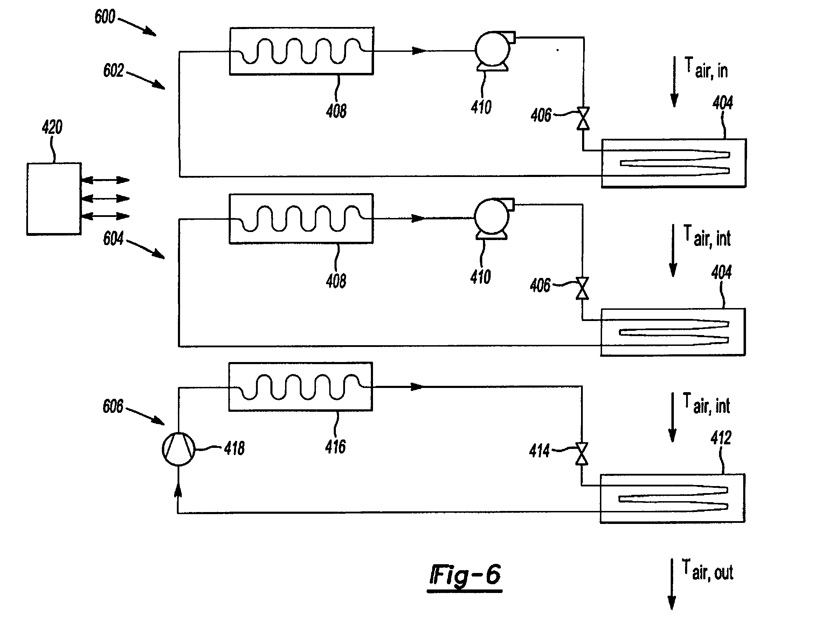

It should be understood that the CRAC can have more than two cooling circuits. Fig. 6 shows a CRAC 600 having three cooling circuits 602, 604, 606. Cooling circuits 602, 604 may illustratively be pumped refrigerant cooling circuits having the same components as cooling circuit 401 (Fig. 4) and cooling circuit 606 may illustratively be a direct expansion cooling circuit having the same components as cooling circuit 402 (Fig. 4). Cooling circuit 602 is the most upstream cooling circuit having its cooling coil 404 disposed in the most upstream position, cooling circuit 606 is the most downstream cooling circuit having its cooling coil 412 disposed in the most downstream location, and cooling circuit 604 has its cooling coil 404 disposed downstream of cooling coil 404 of most upstream cooling circuit 602 and upstream of cooling coil 412 of most downstream cooling circuit 606.

Spatially relative terms, such as "inner," "outer," "beneath", "below", "lower", "above", "upper" and the like, may be used herein for ease of description to describe one element or feature's relationship to another element(s) or feature(s) as illustrated in the figures. Spatially relative terms may be intended to encompass different orientations of the device in use or operation in addition to the orientation depicted in the figures. For example, if the device in the figures is turned over, elements described as "below" or "beneath" other elements or features would then be oriented "above" the other elements or features. Thus, the example term "below" can encompass both an orientation of above and below. The device may be otherwise oriented (rotated 90 degrees or at other orientations) and the spatially relative descriptors used herein interpreted accordingly.

The foregoing description of the embodiments has been provided for purposes of illustration and description. It is not intended to be exhaustive or to limit the invention. Individual elements or features of a particular embodiment are generally not limited to that particular embodiment, but, where applicable, are interchangeable and can be used in a selected embodiment, even if not specifically shown or described. The same may also be varied in many ways. Such variations are not to be regarded as a departure from the invention, and all such modifications are intended to be included within the scope of the invention, as defined by the appended claims.

## Claims

1. A computer room air conditioner (400), comprising:
a cabinet (500) having an air inlet (502) and an air outlet (504);
an air moving unit (508) disposed in the cabinet (500);
a plurality of separate cooling circuits including an upstream cooling circuit (401) and a downstream cooling circuit (402);
the upstream cooling circuit (401) including an upstream cooling coil (404) and the downstream cooling circuit (402) including a downstream cooling coil (412) wherein the cooling coils (404, 412) are arranged so that air to be cooled passes through them in serial fashion, first through the upstream cooling coil (404) and then through the downstream cooling coil (412) wherein the upstream cooling coil (404) is a pre-cooler to the downstream cooling coil (412); and
a controller (420) that controls the cooling circuits (401, 402), the controller controlling the upstream cooling circuit (401) when the upstream cooling circuit (401) is being used to provide cooling to provide only sensible cooling and controlling the downstream cooling circuit (402) to provide any latent cooling that is required and any sensible cooling that is required in addition to the sensible cooling provided by the upstream cooling circuit (401).

2. The computer room air conditioner of claim 1 wherein the controller (420) controls the downstream cooling circuit (402) to provide sensible cooling and any latent cooling that is required and controls the upstream cooling circuit (401) so that it is not providing any cooling.

3. The computer room air conditioner of claim 1 wherein the upstream cooling cool (404) is a microchannel cooling coil and the downstream cooling coil (412) is a fin-and-tube cooling coil.

4. The computer room air conditioner of claim 1 wherein the upstream cooling coil (404) and the downstream cooling coil (412) are both microchannel cooling coils.

5. The computer room air conditioner of claim 1 wherein the upstream cooling coil (404) and the downstream cooling coil (412) are both fin-and-tube cooling coils.

6. The computer room air conditioner of claim 1 wherein the upstream cooling circuit (401) is a pumped refrigerant cooling circuit having the upstream cooling coil (404), a flow regulator (406), a condenser (408) and a pump (410) arranged in the pumped refrigerant cooling circuit, and the downstream cooling circuit (402) is a direct expansion cooling circuit having the downstream cooling coil (412), an expansion valve 414), a condenser (416) and a compressor (418) arranged in the direct expansion cooling circuit.

7. The computer room air conditioner of claim 1 wherein the upstream cooling coil (404) is disposed at the air inlet (502) of the cabinet (500).

8. The computer room air conditioner of claim 1 wherein the upstream cooling coil (404) is disposed at an air inlet of the downstream cooling coil (412).

9. The computer room air conditioner of claim 1 including at least three cooling circuits (602, 604, 606), the controller (420) controlling all but a most downstream cooling circuit (606) to provide only sensible cooling when these cooling circuits (602, 604) are being used to provide cooling.

10. The computer room air conditioner of claim 9 wherein the controller controls the most downstream cooling circuit (606) to provide sensible cooling and any latent cooling that is required and controls the upstream cooling circuits (602, 604) so that they are not providing any cooling.

11. The computer room air conditioner of claim 1 wherein the upstream and downstream cooling coils (404, 412) are disposed in the cabinet (500).

12. The computer room air conditioner of claim 1 wherein the downstream cooling coil (412) is disposed in the cabinet and the upstream cooling coil (404) is in an air inlet plenum 512) outside the cabinet (500) which is coupled to the air inlet (502) of the cabinet (500).

13. The computer room air conditioner of claim 12 wherein the upstream cooling circuit (401) cools air passing through the upstream cooling coil (404) sufficiently so that a cooling capacity of the downstream cooling circuit (402) is sufficient to reduce a temperature of the air passing through the downstream cooling coil (412) to below a dew point of the air to provide latent cooling.

14. The computer room air conditioner of claim 1 wherein the upstream cooling circuit (401) increases a temperature delta across the computer room air conditioner (400) by at least 5.5°C (ten degrees Fahrenheit).

## Patentansprüche

1. Computerraum-Klimaanlage (400), mit
einem Gehäuse (500) mit einem Lufteinlass (502) und einem Luftauslass (504);
einer Luftbewegungseinheit (508), die in dem Gehäuse (500) angeordnet ist;
einer Vielzahl separater Kühlkreisläufe einschließlich eines Upstream-Kühlkreislaufs (401) und eines Downstream-Kühlkreislaufs (402);
wobei der Upstream-Kühlkreislauf (410) eine Upstream-Kühlschlange (404) und der Downstream-Kühlkreislauf (402) eine Downstream-Kühlschlange (412) aufweist, wobei die Kühlschlangen (404, 412) so angeordnet sind, dass zu kühlende Luft nacheinander durch sie hindurchströmt, zunächst durch die Upstream-Kühlschlange (404) und dann durch die Downstream-Kühlschlange (412), wobei die Upstream-Kühlschlange (404) ein Vorkühler für die Downstream-Kühlschlange (412) ist; und
einer Steuereinrichtung (420), die die Kühlkreisläufe (401, 402) steuert, wobei die Steuereinrichtung den Upstream-Kühlkreislauf (401) steuert, wenn der Upstream-Kühlkreislauf (401) zum Kühlen verwendet wird, um nur fühlbare Kühlung bereitzustellen, und den Downstream-Kühlkreislauf (402) steuert, um etwaige latente Kühlung, die benötigt wird, bereitzustellen sowie etwaige fühlbare Kühlung, die zusätzlich zu der von dem Upstream-Kühlkreislauf (401) bereitgestellten fühlbaren Kühlung benötigt wird.

2. Computerraum-Klimaanlage nach Anspruch 1, wobei die Steuereinrichtung (420) den Downstream-Kühlkreislauf (402) steuert, um fühlbare Kühlung und etwaige latente Kühlung, die benötigt wird, bereitzustellen, und den Upstream-Kühlkreislauf (401) so steuert, dass er keine Kühlung bereitstellt.

3. Computerraum-Klimaanlage nach Anspruch 1, wobei die Upstream-Kühlschlange (404) eine Mikrokanal-Kühlschlange ist und die Downstream-Kühlschlange (412) eine Rippenrohr-Kühlschlange ist.

4. Computerraum-Klimaanlage nach Anspruch 1, wobei sowohl die Upstream-Kühlschlange (404) als auch die Downstream-Kühlschlange (412) Mikrokanal-Kühlschlangen sind.

5. Computerraum-Klimaanlage nach Anspruch 1, wobei sowohl die Upstream-Kühlschlange (404) als auch die Downstream-Kühlschlange (412) Rippenrohr-Kühlschlangen sind.

6. Computerraum-Klimaanlage nach Anspruch 1, wobei der Upstream-Kühlkreislauf (401) ein pumpenbetriebener Kältemittel-Kühlkreislauf ist, wobei Upstream-Kühlschlange (404), ein Durchflussregler (406), ein Kondensator (408) und eine Pumpe (410) in dem pumpenbetriebenen Kältemittel-Kühlkreislauf angeordnet sind, und der Downstream-Kühlkreislauf (402) ein Direktexpansions-Kühlkreislauf ist, wobei die Downstream-Kühlschlange (412), ein Expansionsventil (414), ein Kondensator (416) und ein Kompressor (418) in dem Direktexpansions-Kühlkreislauf angeordnet sind.

7. Computerraum-Klimaanlage nach Anspruch 1, wobei die Upstream-Kühlschlange (404) in dem Lufteinlass (502) des Gehäuses (500) angeordnet ist.

8. Computerraum-Klimaanlage nach Anspruch 1, wobei die Upstream-Kühlschlange (404) in einem Lufteinlass der Downstream-Kühlschlange (412) angeordnet ist.

9. Computerraum-Klimaanlage nach Anspruch 1, die wenigstens drei Kühlkreisläufe (602, 604, 606) aufweist, wobei die Steuereinrichtung (420) alle bis auf den am weitesten stromabwärts gelegenen Kühlkreislauf (606) steuert, um nur fühlbare Kühlung bereitzustellen, wenn diese Kühlkreisläufe (602, 604) verwendet werden, um Kühlung bereitzustellen.

10. Computerraum-Klimaanlage nach Anspruch 9, wobei die Steuereinrichtung den am weitesten stromabwärts gelegenen Kühlkreislauf (606) steuert, um fühlbare Kühlung und etwaige latente Kühlung, die benötigt wird, bereitzustellen, und die Upstream-Kühlkreisläufe (602, 604) so steuert, dass sie keine Kühlung bereitstellen.

11. Computerraum-Klimaanlage nach Anspruch 1, wobei die Upstream- und Downstream-Kühlschlangen (404, 412) in dem Gehäuse (500) angeordnet sind.

12. Computerraum-Klimaanlage nach Anspruch 1, wobei die Downstream-Kühlschlange (412) in dem Gehäuse angeordnet ist und die Upstream-Kühlschlange (404) in einer Lufteinlasskammer (512) außerhalb des Gehäuses (500) angeordnet ist, die mit dem Lufteinlass (502) des Gehäuses (500) verbunden ist.

13. Computerraum-Klimaanlage nach Anspruch 12, wobei der Upstream-Kühlkreislauf (401) Luft, die durch die Upstream-Kühlschlange (404) fließt, ausreichend kühlt, so dass die Kühlkapazität des Downstream-Luftkreislaufs (402) ausreicht, um die Temperatur der Luft, die durch die Downstream-Kühlschlange (412) strömt, unter den Taupunkt der Luft zu reduzieren, um latente Kühlung bereitzustellen.

14. Computerraum-Klimaanlage nach Anspruch 1, wobei der Upstream-Kühlkreislauf (401) das Temperaturdelta über die Computerraum-Klimaanlage (400) um wenigstens 5,5°C (10 Grad Fahrenheit) erhöht.

## Revendications

1. Climatiseur de salle d'ordinateurs (400), comprenant :
un boîtier (500) comportant une admission d'air (502) et un refoulement d'air (504) ;
une unité de ventilation (508) disposée dans le boîtier (500) ;
une pluralité de circuits de refroidissement séparés comprenant un circuit de refroidissement amont (401) et un circuit de refroidissement aval (402) ;
le circuit de refroidissement amont (401) comprenant un serpentin de refroidissement amont (404) et le circuit de refroidissement aval (402) comprenant un serpentin de refroidissement aval (412) dans lequel les serpentins de refroidissement (404, 412) sont agencés de sorte que l'air à refroidir à travers eux en série, tout d'abord à travers le serpentin de refroidissement amont (404) puis à travers le serpentin de refroidissement aval (412) dans lequel le serpentin de refroidissement amont (404) est un prérefroidisseur au serpentin de refroidissement aval (412) ; et
une unité de commande (420) qui commande les circuits de refroidissement (401, 402), l'unité de commande commandant le circuit de refroidissement amont (401) lorsque le circuit de refroidissement amont (401) est utilisé pour fournir un refroidissement ne fournissant qu'un refroidissement sensible et commandant le circuit de refroidissement aval (402) pour fournir tout refroidissement latent qui est nécessaire et tout refroidissement sensible qui est nécessaire en plus du refroidissement sensible fourni par le circuit de refroidissement amont (401).

2. Climatiseur de salle d'ordinateurs selon la revendication 1, dans lequel l'unité de commande (420) commande le circuit de refroidissement aval (402) pour fournir un refroidissement sensible et tout refroidissement latent qui est nécessaire et commande le circuit de refroidissement amont (401) de sorte qu'il ne fournisse pas de refroidissement.

3. Climatiseur de salle d'ordinateurs selon la revendication , dans lequel le serpentin de refroidissement amont (404) est un serpentin de refroidissement à microcanaux et le serpentin de refroidissement aval (412) est un serpentin de refroidissement à tube à ailettes.

4. Climatiseur de salle d'ordinateurs selon la revendication 1, dans lequel le serpentin de refroidissement amont (404) et le serpentin de refroidissement aval (412) sont tous deux des serpentins de refroidissement à microcanaux.

5. Climatiseur de salle d'ordinateurs selon la revendication 1, dans lequel le serpentin de refroidissement amont (404) et le serpentin de refroidissement aval (412) sont tous deux des serpentins de refroidissement à tube à ailettes.

6. Climatiseur de salle d'ordinateurs selon la revendication 1, dans lequel le circuit de refroidissement amont (401) est un circuit de refroidissement à fluide frigorigène pompé comportant le serpentin de refroidissement amont (404), un régulateur de débit (406), un condenseur (408) et une pompe (410) agencés dans le circuit de refroidissement à fluide frigorigène pompé, et le circuit de refroidissement aval (402) est un circuit de refroidissement à détente directe comportant le serpentin de refroidissement aval (412), un détendeur (414), un condenseur (416) et un compresseur (418) agencés dans le circuit de refroidissement à détente directe.

7. Climatiseur de salle d'ordinateurs selon la revendication 1, dans lequel le serpentin de refroidissement amont (404) est disposé au niveau de l'admission d'air (502) du boîtier (500).

8. Climatiseur de salle d'ordinateurs selon la revendication 1, dans lequel le serpentin de refroidissement amont (404) est disposé au niveau d'une admission d'air du serpentin de refroidissement aval (412).

9. Climatiseur de salle d'ordinateurs selon la revendication 1, comprenant au moins trois circuits de refroidissement (602, 604, 606), l'unité de commande (420) commandant tout excepté un circuit de refroidissement le plus aval (606) afin de fournir seulement un refroidissement sensible lorsque ces circuits de refroidissement (602, 604) sont utilisés pour fournir un refroidissement.

10. Climatiseur de salle d'ordinateurs selon la revendication 9, dans lequel l'unité de commande commande le circuit de refroidissement le plus aval (606) afin de fournir un refroidissement sensible et tout refroidissement latent qui est nécessaire et commande les circuits de refroidissement amont (602, 604) de sorte qu'ils ne fournissent pas de refroidissement.

11. Climatiseur de salle d'ordinateurs selon la revendication 1, dans lequel les serpentins de refroidissement amont et aval (404, 412) sont disposés dans le boîtier (500).

12. Climatiseur de salle d'ordinateurs selon la revendication 1, dans lequel le serpentin de refroidissement aval (412) est disposé dans le boîtier et le serpentin de refroidissement amont (404) est un plénum d'admission d'air (512) à l'extérieur du boîtier (500) qui est couplé à l'admission d'air (502) du boîtier (500).

13. Climatiseur de salle d'ordinateurs selon la revendication 12, dans lequel le circuit de refroidissement amont (401) refroidit suffisamment l'air passant à travers le serpentin de refroidissement amont (404) de sorte qu'une capacité de refroidissement du circuit de refroidissement aval (402) est suffisante pour réduire une température de l'air passant à travers le serpentin de refroidissement aval (412) jusqu'en dessous d'un point de relevé de l'air afin de fournir un refroidissement latent.

14. Climatiseur de salle d'ordinateurs selon la revendication 1, dans lequel le circuit de refroidissement amont (401) augmente un delta de température à travers le climatiseur de salle d'ordinateurs (400) d'au moins 5,5 °C (dix degrés Fahrenheit).
